# EUROPEAN PATENT APPLICATION

(11) **EP 4 386 813 A1**
(43) Date of publication of application: **19.06.2024**
(21) Application number: 22855770.8
(22) Date of filing: 14.07.2022
(51) Int. Cl.: H01L 21/205, C23C 16/44

(54) **REFLECTOR UNIT AND FILM FORMING DEVICE**

(30) Priority: 12.08.2021 JP 2021131789
(71) Applicant: NuFlare Technology, Inc., Yokohama-shi, Kanagawa 235-8522 (JP)
(72) Inventor: UMETSU, Takuto, Yokohama-shi, Kanagawa 235-8522 (JP); YAJIMA, Masayoshi, Yokohama-shi, Kanagawa 235-8522 (JP); SUZUKI, Kunihiko, Yokohama-shi, Kanagawa 235-8522 (JP)
(74) Representative: Hoffmann Eitle
(86) International application number: PCT/JP2022/027649
(87) International publication number: WO 2023/017706

(57) **Abstract**

[Problem]

The present embodiments provide a reflector unit and a film forming apparatus that can sufficiently suppress heat conduction to a chamber and reduce the generation of stress on the chamber.

[Solution]

A reflector unit includes a cylindrical first reflector component having a first engagement portion on an outer circumference side to be supported by a film formation chamber and having a first mounting portion on an inner circumference side, and a cylindrical second reflector component arranged on an inner side of the first reflector component and having a second engagement portion on an outer circumference side to engage with the first reflector component on the first mounting portion to be supported by the first reflector component.

## Description

### Field

The embodiments of the present invention relate to a reflector unit and a film forming apparatus.

### Background

An epitaxial growth technique of vapor-growing a single-crystal thin film (for example, SiC (silicon carbide)) to be deposited on a substrate is conventionally used in a manufacturing process of a semiconductor element such as a power device. In a film forming apparatus used in the epitaxial growth technique, a substrate is placed inside a chamber kept at a normal pressure or a reduced pressure, and a source gas and a doping gas are supplied to the inside of the chamber while the substrate is rotated and heated. This causes a pyrolytic reaction and a hydrogen reduction reaction of the source gas on the surface of the substrate, and an epitaxial film is deposited on the substrate.

When a circular top plate to which an introducer of the source gas is connected and that constitutes an upper part of the chamber is heated by radiant heat or conductive heat, a large stress is generated on the chamber. In order to suppress this stress application to the chamber, a reflector unit is provided on an inner circumference of the top plate.

### Citation List

### Patent Literatures

Patent Literature 1: Japanese Patent Application Laid-open No. 2010-116606
Patent Literature 1: Japanese Patent Application Laid-open No. 2013-211521
Patent Literature 1: Japanese Patent Application Laid-open No. 2018-082064

### Summary

### Technical Problem

It is important that the structure near the gas introducer suppresses heat radiation and heat conduction, while it is also important to facilitate maintenance, etc. of the structure with the chamber open to maintain it. However, depending on the shape of the reflector, the shape of chamber and the method of fixing them, the chamber may be affected by heat conduction from the components and its own temperature distribution. This causes significant stress in the chamber.

The present embodiments provide a reflector unit and a film forming apparatus that can sufficiently suppress heat conduction to a chamber and reduce the generation of stress on the chamber.

### Solution to Problem

A reflector unit according to the present embodiment includes: a cylindrical first reflector component having a first engagement portion on an outer circumference side to be supported by a film formation chamber, and a first mounting portion on an inner circumference side; and a cylindrical second reflector component arranged on an inner side of the first reflector component and having a second engagement portion on an outer circumference side to engage with the first reflector component on the first mounting portion to be supported by the first reflector component.

A film forming apparatus according to the present embodiment includes: a chamber including a top plate having an opening on an upper part, and configured to accommodate a substrate to perform film formation processing; a gas supplier located above the chamber and configured to supply a source gas onto the substrate through the opening of the top plate; a heater configured to heat the substrate; and the above reflector unit installed in the opening of the top plate.

### Brief Description of Drawings

FIG. 1 is a cross-sectional view illustrating a configuration example of a film forming apparatus according to a first embodiment;
FIG. 2 is a cross-sectional view illustrating a configuration example of a reflector unit and its surroundings;
FIG. 3 is a cross-sectional view illustrating a configuration example of a first reflector unit;
FIG. 4A is a plan view illustrating a configuration example of a reflector component;
FIG. 4B is a cross-sectional view along a line B-B in FIG. 4A;
FIG. 4C is a side view illustrating the configuration example of the reflector component;
FIG. 5A is a plan view illustrating a configuration example of another reflector component;
FIG. 5B is a cross-sectional view along a line B-B in FIG. 5A;
FIG. 5C is a side view illustrating the configuration example of the reflector component;
FIG. 6 is a cross-sectional view illustrating a configuration example of a first reflector unit according to a second embodiment;
FIG. 7 is a cross-sectional view illustrating a configuration example of a first reflector unit according to a modification of the first embodiment;
FIG. 8A is a cross-sectional view illustrating a configuration example of a first reflector unit according to a third embodiment;
FIG. 8B is a cross-sectional view illustrating a more detailed configuration example of the first reflector unit;
FIG. 9A is a diagram illustrating a configuration example of a first support member;
FIG. 9B is a diagram illustrating a configuration example of the first support member;
FIG. 9C is a diagram illustrating a configuration example of the first support member;
FIG. 10A is a diagram illustrating a configuration example of a second support member;
FIG. 10B is a diagram illustrating a configuration example of the second support member;
FIG. 11 is a perspective view illustrating a configuration example of the coupled first and second support members;
FIG. 12A is a side view illustrating another configuration example of the coupled first support member; and
FIG. 12B is a plan view illustrating the configuration example of the coupled first support member.

### Description of Embodiments

Embodiments will now be explained with reference to the accompanying drawings. The present invention is not limited to the embodiments. In the present specification and the drawings, elements identical to those described in the foregoing drawings are denoted by like reference characters and detailed explanations thereof are omitted as appropriate.

### (First embodiment)

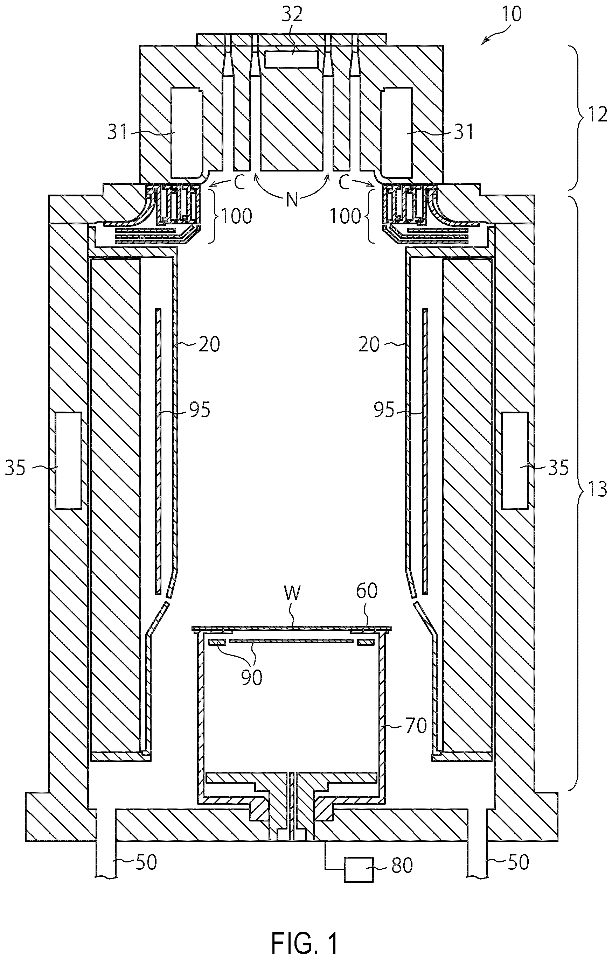

FIG. 1 is a cross-sectional view illustrating a configuration example of a film forming apparatus 10 according to a first embodiment. The film forming apparatus 10 includes a chamber 13, a liner 20, coolers 31, 32, and 35, a gas supplier 12, a discharging portion 50, a susceptor 60, a support 70, a rotation mechanism 80, a lower heater 90, an upper heater 95, and a reflector unit 100.

The chamber 13 is constituted of a substantially cylindrical metal and is made of, for example, stainless steel. The pressure in the chamber 13 can be adjusted by a vacuum pump (not illustrated) connected to the discharging portion 50.

The gas supplier 12 above the chamber 13 includes a plurality of nozzles N for supplying gases, a first cooler 31, and a second cooler 32. A process gas including a source gas, a carrier gas, and a doping gas supplied through the nozzles N is suppressed from increasing in the temperature by the first cooler 31 and the second cooler 32.

The chamber 13 can accommodate a substrate W and film formation processing is performed therein. The susceptor 60, the rotation mechanism 80, the lower heater 90, the upper heater 95, and the like are installed in the chamber 13. The gases supplied through the nozzles N react on the surface of the heated substrate W and an epitaxial film is formed on the substrate W. This epitaxial film is, for example, a SiC film.

The liner 20 is a hollow tubular member that covers and protects the inner wall of the chamber 13 and is made of, for example, carbon coated with SiC. The liner 20 suppresses deposition of by-products on the inner wall of the chamber 13.

The coolers 31 and 32 are provided in the gas supplier 12 and are, for example, flow channels for a refrigerant (for example, water). With flow of the refrigerant through the flow channels, the coolers 31 and 32 suppress a temperature increase of the gases caused by heat from the upper heater 95 or the lower heater 90 in the gas supplier 12 and around the nozzles N of the gas supplier 12.

The cooler 35 is provided in the chamber 13 and is, for example, a flow channel for a refrigerant (for example, water) similarly to the coolers 31 and 32. The cooler 35 is provided to prevent the heat from the upper heater 95 or the lower heater 90 from heating the chamber 13.

The gas supplier 12 is installed above the chamber 13 to oppose the surface of the substrate W, and has the nozzles N. The gas supplier 12 supplies the source gas, the doping gas, and the carrier gas to the inside of the chamber 13 through the nozzles N.

The discharging portion 50 is provided on the bottom of the chamber 13 and discharges a surplus of the gases used in the film formation processing or reaction by-products to outside the chamber 13.

The susceptor 60 is an annular member on which the substrate W can be placed and is made of, for example, a material such as SiC or carbon. The support 70 is a cylindrical member that can support the susceptor 60 and is made of, for example, carbon similarly to the susceptor 60. The support 70 is connected to the rotation mechanism 80 and is configured to be rotatable by the rotation mechanism 80. The support 70 can rotate the substrate W along with the susceptor 60. The susceptor 60 and the support 70 are made of, for example, a material having a resistance to heat equal to or higher than 1700°C, such as SiC, TaC (tantalum carbide), or carbon coated with TaC, as well as carbon.

The lower heater 90 is installed below the susceptor 60 and inside the support 70. The lower heater 90 heats the substrate W from below. The upper heater 95 is installed along the side surface of the chamber 13 and heats inside the chamber 13 to prevent the temperature of the substrate W from lowering. The upper heater 95 is installed below the reflector unit 100. While the rotation mechanism 80 rotates the substrate W at a high speed, for example, equal to or higher than 900 rpm, the lower heater 90 and the upper heater 95 heat the substrate W to a high temperature equal to or more than 1500°C. This enables the substrate W to be uniformly heated.

The reflector unit 100 is installed inside the circular top plate 110 provided at an upper part of the chamber 13 and is made of, for example, carbon. The reflector unit 100 reflects heat from the lower heater 90 and the upper heater 95 to a downward direction and suppresses heat conduction to the chamber 13. This prevents the temperatures of the gas supplier 12 and the upper part of the chamber 13 from excessively increasing. For example, it is preferable that the reflector unit 100 is made of a material having a resistance to heat equal to or higher than 1700°C, such as SiC, TaC, W (tungsten), or Mo (molybdenum), as well as carbon. The reflector unit 100 has a configuration in which a plurality of thin plates are arranged at predetermined distances to efficiently reflect heat. A more detailed configuration of the reflector unit 100 will be described later.

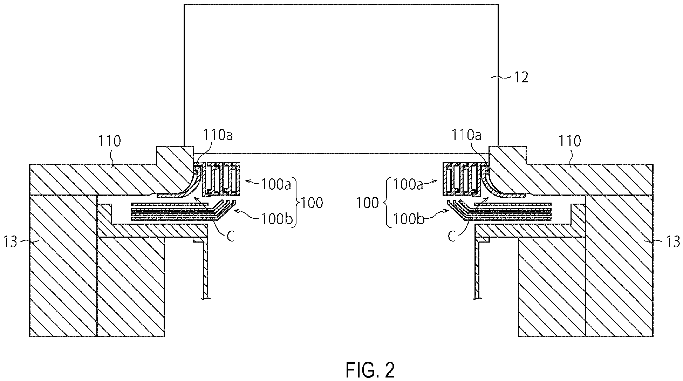

FIG. 2 is a cross-sectional view illustrating a configuration example of the reflector unit 100 and its surroundings. Illustrations of the gas supplier 12 are omitted in FIG. 2.

The reflector unit 100 is provided at an upper part of the chamber 13 (that is, immediately under the gas supplier 12) and includes a first reflector unit 100a and a second reflector unit 100b.

The first reflector unit 100a is attached to the top plate 110 provided at the upper part of the chamber 13. The top plate 110 constitutes the upper part of the chamber 13. The top plate 110 is a circular member provided substantially concentrically with the chamber 13 and is constituted of, for example, a metal such as stainless steel. The top plate 110 is configured in such a manner that a lower part of an inner circumferential portion C has a predetermined curvature from a substantially vertical direction to a substantially horizontal direction. Accordingly, concentration of a stress caused by heat in the film formation processing on the lower part of the inner circumferential portion C of the top plate 110 is suppressed.

In order to suppress heat due to the film formation processing and protect the chamber 13, the reflector unit 100 is installed on the inner circumferential side of the top plate 110.

The top plate 110 has a plurality of protruded portions 110a on the inner wall surface. The first reflector unit 100a is supported to be hung on the protruded portions 110a of the top plate 110 by its own weight with a top plate cover (hereinafter, simply "cover") 103 described later interposed therebetween, and is not fastened by bolts or the like. The first reflector unit 100a is composed of a plurality of reflector components. The reflector components all have substantially cylindrical shapes and are arranged at the inner circumferential portion C of the top plate 110 in a nested manner by engaging with or being supported by each other.

Meanwhile, the second reflector unit 100b is attached on an inner wall surface of the chamber 13 extending in a substantially horizontal direction. The second reflector unit 100b is composed of a plurality of stacked reflector components and is fastened and fixed to the chamber 13 by bolts or the like with a holding member interposed therebetween.

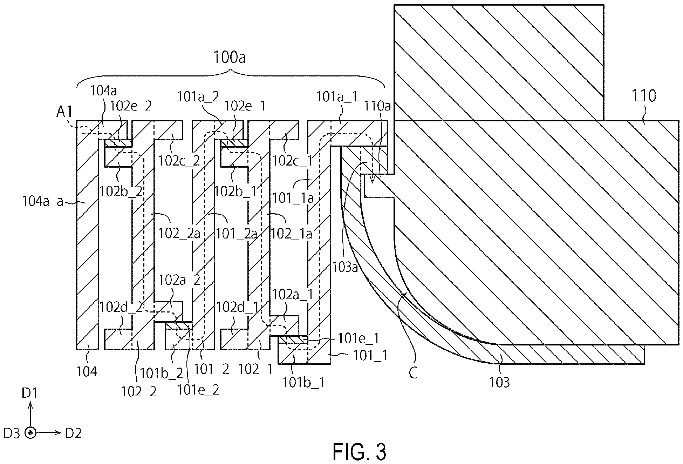

FIG. 3 is a cross-sectional view illustrating a configuration example of the first reflector unit 100a. The circumferential direction of the cylindrical shape of the first reflector unit 100a is denoted by D3, the radial direction is denoted by D2, and a direction orthogonal to the directions D3 and D2 is denoted by D1. The direction D1 is the vertical direction (a vertically upper direction or a vertically lower direction). FIG. 3 illustrates a cross section of an installation portion of the first reflector unit 100a in the radial direction (D2). These directions do not need to be exactly vertical or horizontal and a certain level of error is allowable.

The cover 103 covers the inner wall of the chamber 13 at the inner circumferential portion C of the top plate 110 located between the gas supplier 12 and the chamber 13. The cover 103 is provided along a curved part of the inner circumferential portion C of the top plate 110. The cover 103 is provided, for example, to prevent adhesion of reaction by-products to the top plate 110.

The cover 103 is formed in a substantially circular shape along the inner wall of the chamber 13. The cover 103 has a plurality of engagement portions 103a. The engagement portions 103a are configured, for example, by providing a plurality of cutouts on a flange formed on an upper part of the cover 103 on the outer circumference side, and engage with the protruded portions 110a provided on the inner circumference side of the top plate 110. Accordingly, the cover 103 is supported on the protruded portions 110a by its own weight with the engagement portions 103a, and covers the inner circumferential surface of the top plate 110. For example, a heat-resistant material such as quartz is used for the cover 103.

The cover 103 has a diameter slightly smaller than the inside diameter of the top plate 110 to be capable of covering the inner circumferential surface of the top plate 110. Meanwhile, the outside diameter of the engagement portions 103a is larger than the inside diameter of an inscribed circle of the protruded portions 110a to enable the engagement portions 103a to be caught on the protruded portions 110a. With this configuration, the cover 103 can be fixed in a state of covering the inner circumferential surface of the top plate 110.

The cover 103 engages with the protruded portions 110a provided on the inner circumferential portion C of the top plate 110 via the engaging portions 103a and is supported by the protruded portions 110a. The protruded portions 110a are provided to be protruded in the radial direction from the inner wall of the top plate 110. The protruded portions 110a are formed integrally with the top plate 110 and are constituted of a metal such as stainless steel similarly to the top plate 110. The protruded portions 110a may be different members from the top plate 110. In this case, it suffices that the protruded portions 110a are, for example, bonded or welded to the side wall of the top plate 110.

The first reflector unit 100a includes reflector components 101_1, 101_2, 102_1, 102_2, and 104.

The reflector component 101_1 as a first reflector component has a substantially cylindrical shape to cover the inner circumferential portion C of the top plate 110. That is, the reflector component 101_1 is arranged in such a manner that the side wall covers the inner circumferential portion C of the top plate 110 in the vertical direction (D1) and the circumferential direction (D3). For example, a heat-resistant material such as carbon, carbon coated with SiC, or carbon coated with TaC is used as the reflector components 101_1, 102_1, 101_2, 102_2, and 104. For example, a material including a SiC film or a TaC film deposited on carbon may be used as the reflector components 101_1, 102_1, 101_2, 102_2, and 104.

The reflector component 101_1 has an engagement portion 101a_1 as a first engagement portion that is protruded outward at an upper end and has a plurality of mounting portions 101b_1 as a first mounting portion protruded inward at a lower end, in a cross section in the radial direction (D2). The engagement portion 101a_1 engages with upper parts of the protruded portions 110a provided on the inner circumferential portion C of the top plate 110 with the engagement portion 103a of the cover 103 interposed therebetween, and is supported by the protruded portions 110a. The mounting portions 101b_1 are protruded inward to mount the reflector component 102_1 as a second reflector component. As described above, the reflector component 101_1 has the engagement portion 101a_1 at the upper end and the mounting portions 101b_1 at the lower end. Accordingly, the reflector component 101_1 engages with the protruded portion 110a of the top plate 110 by its own weight to be supported by the protruded portions 110a, and can mount and support the reflector component 102_1 on the mounting portions 101b_1.

A part 101_1a of the reflector component 101_1 extending in the vertical direction (D1) has an outside diameter slightly smaller than the inside diameter of the cover 103 to enable the part 101_1a to be placed on the inner side of the cover 103. Meanwhile, the diameter of a circumscribed circle of the engagement portion 101a_1 is slightly larger than the inside diameter of the cover 103 or the diameter of an inscribed circle of the protruded portions 110a to cause the engagement portion 101a_1 to be hung on the cover 103 or the protruded portions 110a. With this configuration, the reflector component 101_1 can be placed in a state of covering the inner circumferential portion C of the top plate 110 and the inner circumferential surface of the cover 103.

The engagement portion 101a_1 suppresses heat radiation from above from entering between the reflector component 101_1 and the cover 103 and suppresses the reflector component 101_1 and the cover 103 from being directly heated by the heat radiation. The mounting portions 101b_1 suppress heat radiation from below from entering between the reflector component 101_1 and the reflector component 102_1 and suppress the reflector components 101_1 and 102_1 from being directly heated by the heat radiation. Furthermore, the engagement portion 101a_1 suppresses the process gas from above from entering between the reflector component 101_1 and the cover 103 and suppresses deposits from adhering to the reflector component 101_1 and the cover 103. Accordingly, the reflectances of heat radiation of the reflector components 101_1 and the cover 103 can be maintained. The mounting portions 101b_1 suppress the process gas from below from entering between the reflector component 101_1 and the reflector component 102_1 and suppress deposits from adhering to the reflector components 101_1 and 102_1. This enables the reflectances of heat radiation of the reflector components 101_1 and 102_1 to be maintained.

The reflector component 102_1 as a second reflector component has a substantially cylindrical shape to cover the inner circumferential portion C of the top plate 110. That is, the reflector component 102_1 is arranged in such a manner that the side wall covers the inner surface of the reflector component 101_1 in the vertical direction (D1) and the circumferential direction (D3).

The reflector component 102_1 has a plurality of mounting portions 102b_1 as a second mounting portion protruded inward at an upper part, and has an engagement portion 102a_1 as a second engagement portion protruded outward at a lower part, in a cross section in the radial direction (D2). The engagement portion 102a_1 engages with the mounting portions 101b_1 of the reflector component 101 and is supported by the mounting portions 101b_1. The mounting portions 102b_1 are protruded inward to mount the reflector component 101_2. As described above, the reflector component 102_1 has the mounting portions 102b_1 at the upper part and has the engagement portion 102a_1 at the lower part. Accordingly, the reflector component 102_1 engages with the mounting portions 101b_1 of the reflector component 101_1 by its own weight to be supported by the mounting portions 101b_1 and can mount and support the reflector component 101_2.

A part 102_1a of the reflector component 102_1 extending in the vertical direction (D1) has an outside diameter slightly smaller than the inside diameter of the reflector component 101_1 to enable the part 102_1a to be placed on the inner side of the reflector component 101_1. Meanwhile, the diameter of a circumscribed circle of the engagement portion 102a_1 is slightly larger than the diameter of an inscribed circle of the mounting portions 101b_1 of the reflector component 101_1 to cause the engagement portion 102a_1 to be hung on the mounting portions 101b_1 of the reflector component 101_1. With this configuration, the reflector component 102_1 is placed in a state of covering the inner circumferential surface of the reflector component 101_1.

The reflector component 102_1 further has a protruded portion 102c_1 protruded outward in the radial direction (D2) at the upper end, and further has a protruded portion 102d_1 protruded inward in the radial direction (D2) at the lower end. The protruded portion 102c_1 suppresses heat radiation from above from entering between the reflector component 101_1 and the reflector component 102_1, and suppresses the reflector components 101_1 and 102_1 from being directly heated by the heat radiation. The protruded portion 102d_1 suppresses heat radiation from below from entering between the reflector component 102_1 and the reflector component 101_2 and suppresses the reflector components 102_1 and 101_2 from being directly heated by the heat radiation. Furthermore, the protruded portion 102c_1 suppresses the process gas from above from entering between the reflector component 101_1 and the reflector component 102_1, and suppresses deposits from adhering to the reflector components 101_1 and 102_1. Accordingly, the reflectances of heat radiation of the reflector components 101_1 and 102_1 can be maintained. The protruded portion 102d_1 suppresses the process gas from below from entering between the reflector component 102_1 and the reflector component 101_2, and suppresses deposits from adhering to the reflector components 102_1 and 101_2. Accordingly, the reflectances of heat radiation of the reflector components 102_1 and 101_2 can be maintained.

The engagement portion 102a_1 and the mounting portions 102b_1 also have functions identical to those of the protruded portions 102c_1 and 102d_1. That is, the engagement portion 102a_1 suppresses the heat radiation from below from entering between the reflector component 101_1 and the reflector component 102_1. The mounting portions 102b_1 suppress the heat radiation from above from entering between the reflector component 102_1 and the reflector component 101_2. Furthermore, the engagement portion 102a_1 suppresses the process gas from below from entering between the reflector component 101_1 and the reflector component 102_1. The mounting portions 102b_1 suppress the process gas from above from entering between the reflector component 102_1 and the reflector component 101_2.

The reflector component 101_2 as a third reflector component has basically the same sectional configuration as that of the reflector component 101_1. The reflector component 101_2 has a substantially cylindrical shape to cover the inner wall of the chamber 13 at the inner circumferential portion C. The reflector component 101_2 is arranged in such a manner that the side wall covers the inner circumferential portion C of the top plate 110 substantially in the vertical direction (D1) and the circumferential direction (D3).

The reflector component 101_2 has an engagement portion 101a_2 protruded to the outer circumference side at an upper end and has a plurality of mounting portions 101b_2 protruded to the inner circumference side at the lower end, in a cross section in the radial direction (D2). The engagement portion 101a_2 engages with the mounting portions 102b_1 of the reflector component 102_1 adjacent on the outer side and is supported by the mounting portions 102b_1. The mounting portions 101b_2 of the reflector component 101_2 are protruded to the inner circumference side to mount the reflector component 102_2. As described above, the reflector component 101_2 has the engagement portion 101a_2 at the upper end and the mounting portions 101b_2 at the lower end. Accordingly, the reflector component 101_2 engages with the mounting portions 102b_1 of the reflector component 102_1 by its own weight to be supported thereby, and can mount and support the reflector component 102_2.

A part 101_2a of the reflector component 101_2 extending in the vertical direction (D1) has an outside diameter slightly smaller than the inside diameter of the reflector component 102_1 to enable the part 101_2a to be placed on the inner side of the reflector component 102_1. Meanwhile, the diameter of a circumscribed circle of the engagement portion 101a_2 of the reflector component 101_2 is slightly larger than the diameter of an inscribed circle of the mounting portions 102b_1 of the reflector component 102_1 to cause the engagement portion 101a_2 to be hung on the mounting portions 102b_1 of the reflector component 102_1. With this configuration, the reflector component 101_2 can be placed in a state of covering the reflector component 102_1.

The engagement portion 101a_2 also has functions identical to those of the engagement portion 101a_1 and suppresses the heat radiation from above from entering between the reflector component 102_1 and the reflector component 101_2. The mounting portions 101b_2 also have functions identical to those of the mounting portions 101b_1 and suppress the heat radiation from below from entering between the reflector component 101_2 and the reflector component 102_2. Furthermore, the engagement portion 101a_2 suppresses the process gas from above from entering between the reflector component 102_1 and the reflector component 101_2. The mounting portions 101b_2 suppress the process gas from below from entering between the reflector component 101_2 and the reflector component 102_2. Accordingly, the engagement portion 101a_2 and the mounting portions 101b_2 can provide effects identical to those of the engagement portion 101a_1 and the mounting portions 101b_1.

The reflector component 102_2 has basically the same sectional configuration as that of the reflector component 102_1. The reflector component 102_2 has a substantially cylindrical shape to cover the inner wall of the chamber 13 at the inner circumferential portion C of the top plate 110. The reflector component 102_2 is arranged in such a manner that the side wall covers the inner surface of the reflector component 102_1 in the vertical direction (D1) and the circumferential direction (D3).

The reflector component 102_2 has a plurality of mounting portions 102b_2 protruded inward in the radial direction at an upper part, and has an engagement portion 102a_2 extending outward in the radial direction at a lower part, in a cross section in the radial direction (D2). The engagement portion 102a_2 of the reflector component 102_2 engages with the mounting portions 101b_2 of the reflector component 101_2 and is supported by the mounting portions 101b_2 of the reflector component 101_2. The mounting portions 102b_2 of the reflector component 102_2 are protruded inward in the radial direction to mount the reflector component 104. As described above, the reflector component 102_2 has the mounting portions 102b_2 at the upper part of the body extending in the vertical direction (D1) and has the engagement portion 102a_2 at the lower part. Accordingly, the reflector component 102_2 engages with the mounting portions 101b_2 of the reflector component 101_2 by its own weight to be supported thereby and can mount and support the reflector component 104.

A part 102_2a of the reflector component 102_2 extending in the vertical direction (D1) has an outside diameter slightly smaller than the inside diameter of the reflector component 101_2 to enable the part 102_2a to be placed on the inner side of the reflector component 101_2. Meanwhile, the diameter of a circumscribed circle of the engagement portion 102a_2 of the reflector component 102_2 is slightly larger than the diameter of an inscribed circle of the mounting portions 101b_2 of the reflector component 101_2 to cause the engagement portion 102a_2 to be hung on the mounting portions 101b_2 of the reflector component 101_2. With this configuration, the reflector component 102_2 can be placed in a state of covering the inner circumferential surface of the reflector component 101_2.

The reflector component 102_2 further has a protruded portion 102c_2 protruded outward in the radial direction (D2) at the upper end, and further has a protruded portion 102d_2 protruded inward in the radial direction (D2) at the lower end. The protruded portion 102c_2 suppresses the heat radiation from above from entering between the reflector component 101_2 and the reflector component 102_2, and suppresses the reflector components 101_2 and 102_2 from being directly heated by the heat radiation. The protruded portion 102d_2 suppresses the heat radiation from below from entering between the reflector component 102_2 and the reflector component 104, and suppresses the reflector component 102_2 from being directly heated by the heat radiation. Furthermore, the protruded portion 102c_2 suppresses the process gas from above from entering between the reflector component 101_2 and the reflector component 102_2, and suppresses deposits from adhering to the reflector components 101_2 and 102_2. This enables the reflectances of heat radiation of the reflector components 101_2 and 102_2 to be maintained. The protruded portion 102d_2 suppresses the process gas from below from entering between the reflector component 102_2 and the reflector component 104, and suppresses deposits from adhering to the reflector components 102_2 and 104. Accordingly, the reflectances of heat radiation of the reflector components 102_2 and 104 can be maintained.

The engagement portion 102a_2 and the mounting portions 102b_2 also have functions identical to those of the protruded portions 102c_2 and 102d_2. That is, the engagement portion 102a_2 suppresses the heat radiation from below from entering between the reflector component 101_2 and the reflector component 102_2. The mounting portions 102b_2 suppress the heat radiation from above from entering between the reflector component 102_2 and the reflector component 104. Furthermore, the engagement portion 102a_2 suppresses the process gas from below from entering between the reflector component 101_2 and the reflector component 102_2. The mounting portions 102b_2 suppress the process gas from above from entering between the reflector component 102_2 and the reflector component 104.

The reflector component 104 has a substantially cylindrical shape to cover the inner wall of the reflector component 102_2 at the inner circumferential portion C of the top plate 110. The reflector component 104 can be, for example, a material obtained by depositing a SiC film or a TaC film on a carbon material. However, since the reflector component 104 is the innermost reflector component of the first reflector unit 100a, it is preferable that the reflector component 104 is formed of a material obtained by coating a carbon material with a SiC film.

The reflector component 104 has an engagement portion 104a protruded outward in the radial direction (D2) at the upper end. The engagement portion 104a of the reflector component 104 engages with the mounting portions 102b_2 of the reflector component 102_2 adjacent on the outer side and is supported by the mounting portions 102b_2. As described above, the reflector component 104 has the engagement portion 104a at the upper end of the body extending in the vertical direction (D1). Accordingly, the reflector component 104 can engage with the mounting portions 102b_2 of the reflector component 102_2 by its own weight and can be supported thereby.

A part 104a_a of the reflector component 104 extending in the vertical direction (D1) has an outside diameter slightly smaller than the inside diameter of the reflector component 102_2 to enable the part 104a_a to be placed on the inner side of the reflector component 102_2. Meanwhile, the diameter of a circumscribed circle of the engagement portion 104a is slightly larger than the diameter of an inscribed circle of the mounting portions 102b_2 of the reflector component 102_2 to cause the engagement portion 104a to be hung on the mounting portions 102b_2 of the reflector component 102_2. With this configuration, the reflector component 104 can be placed in a state of covering the inner circumferential surface of the reflector component 102_2.

The engagement portion 104a also has functions identical to those of the engagement portion 101a_2 and suppresses the heat radiation from above from entering between the reflector component 102_2 and the reflector component 104. Furthermore, the engagement portion 104a suppresses the process gas from above from entering between the reflector component 102_2 and the reflector component 104. Accordingly, the engagement portion 104a can provide effects identical to those of the engagement portion 101a_2.

As described above, the first reflector unit 100a according to the present embodiment is composed of the reflector components 101_1, 101_2, 102_1, 102_2, and 104. The reflector components 101_1, 101_2, 102_1, 102_2, and 104 are arranged to be sequentially hung on from the protruded portion 110a of the top plate 110 as a starting point. Accordingly, in the reflector components 101_1, 101_2, 102_1, 102_2, and 104, a reflector component located outside in the radial direction supports a reflector component located inside in the radial direction. Therefore, in the present embodiment, it is unnecessary to fix the reflector components using fasteners such as bolts. Since no fastener such as a bolt is used, heat conduction through fasteners is suppressed. Since no fastener such as a bolt is used, detachment and attachment of the first reflector unit 100a is easy and the maintenance is easily performed. Furthermore, the number of components constituting the first reflector unit 100a is reduced.

For fastening with fasteners, it is necessary to form fastening holes on the reflector components 101_1, 101_2, 102_1, 102_2, and 104 and the top plate 110 and secure these reflector components with fasteners. In this case, a mechanical stress is applied to the first reflector unit 100a and the top plate 110. If such a mechanical stress is applied to the top plate 110 in addition to a thermal stress, the chamber 13 is likely to be damaged. In contrast thereto, since no fastener is used in the first reflector unit 100a according to the present embodiment, application of a mechanical stress to the top plate 110, that is, the chamber 13 can be suppressed.

Furthermore, the reflector components 101_1, 101_2, 102_1, 102_2, and 104 each extend in the vertical direction (D1) and are arranged in a nested manner in the radial direction (D2). Accordingly, the first reflector unit 100a can effectively reflect heat radiation from a substantially horizontal direction. The second reflector unit 100b is composed of the reflector components arranged to be stacked in the vertical direction (D1). Therefore, heat radiation from below the upper heater 95 or the lower heater 90 can be effectively reflected by the second reflector unit 100b. Accordingly, the reflector units 100a and 100b can suppress heat conduction to the top plate 110 and can suppress excessive heating due to heat radiation. This can suppress damages of the chamber 13 due to a thermal stress.

While being different in the diameter size, the reflector components 101_1 and 101_2 have substantially the same shapes in the cross section illustrated in FIG. 3. The reflector components 102_1 and 102_2 also have substantially the same shapes in the cross section illustrated in FIG. 3 while being different in the diameter size. Therefore, in the first reflector unit 100a, the first reflector components 101_1 and 101_2 and the second reflector components 102_1 and 102_2 are alternately arrayed to be stacked in a layered manner in the radial direction. The number of each of the first and second reflector components located between the cover 103 and the reflector component 104 is not particularly limited to two, and can be less than two or more than two.

In the present embodiment, the engagement portion 101a_1 of the reflector component 101_1 is in contact with the engagement portion 103a of the cover 103, the engagement portion 102a_1 of the reflector component 102_1 is in contact with the mounting portions 101b_1 of the reflector component 101_1, the mounting portions 102b_1 of the reflector component 102_1 are in contact with the engagement portion 101a_2 of the reflector component 101_2, the mounting portions 101b_2 of the reflector component 101_2 are in contact with the engagement portion 102a_2 of the reflector component 102_2, and the mounting portions 102b_2 of the reflector component 102_2 are in contact with the engagement portion 104a of the reflector component 104. However, the cover 103 and the reflector components 101_1, 102_1, 101_2, 102_2, and 104 are not in contact with each other in other parts. Therefore, contact surfaces between adjacent reflector components are located at end portions of the reflector components, are distant in the vertical direction (D1) (the height positions thereof in the vertical direction differ), and are arranged to be alternating in a zigzag manner. Accordingly, a heat conducting path from the reflector component 104 located on the innermost side of the first reflector unit 100a to the top plate 110 is long as indicated by a dashed arrow A1 in FIG. 3. With this long heat conducting path, heat of the reflector component 104 is less likely to be conducted to the top plate 110. As a result, the first reflector unit 100a can effectively block heat radiation from the horizontal direction and can protect the top plate 110 from heat.

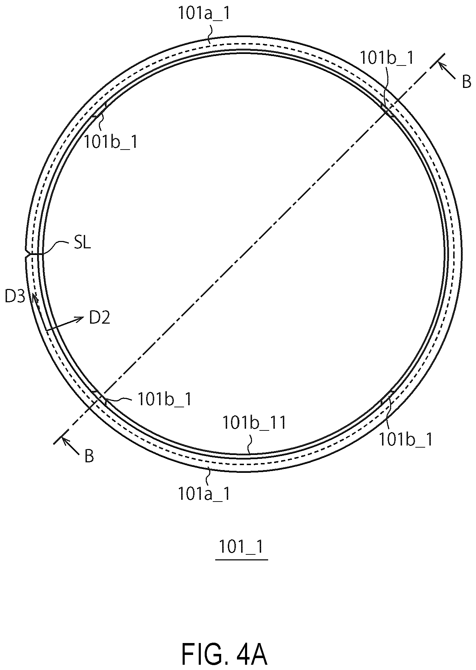

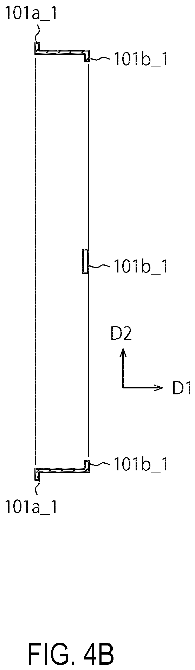

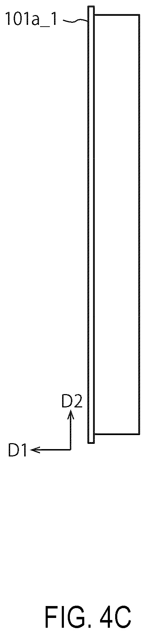

FIG. 4A is a plan view illustrating a configuration example of the reflector component 101_1. FIG. 4B is a cross-sectional view along a line B-B in FIG. 4A. FIG. 4C is a side view illustrating the configuration example of the reflector component 101_1. The configuration of the reflector component 101_1 is explained with reference to FIGS. 4A to 4C. Since the configuration of another reflector component 101_2 is basically the same as that of the reflector component 101_1 while the diameter is different, explanations thereof are omitted. The reflector component 101_1 is made of, for example, a material obtained by depositing a SiC film or a TaC film on a carbon material.

As illustrated in FIG. 4A, the reflector component 101_1 includes, on the inner side, a flange 101b_11 protruded in the radial direction (D2) and provided entirely in the circumferential direction (D3), and the mounting portions 101b_1 protruded in the vertical direction (D1) on the flange 101b_11. That is, the mounting portions 101b_1 are provided on the flange 101b_11 of the reflector component 101_1. The mounting portions 101b_1 are not provided on the entire inner circumference of the reflector component 101_1 but are arranged partly and substantially uniformly at four positions on the inner circumference as illustrated in FIG. 4A. It suffices that the mounting portions 101b_1 can stably support the reflector component 101_1 and are substantially uniformly arranged at least at three positions.

If the mounting portions 101b_1 are provided on the entire inner circumference of the reflector component 101_1, the engagement portion 102a_1 of the reflector component 102_1 is in contact with the flange 101b_11 and the contact area therebetween is increased. In this case, the thermal conductivity between the reflector component 101_1 and the reflector component 102_1 becomes relatively high. Therefore, the heat insulation effect of the first reflector unit 100a is reduced.

Accordingly, the mounting portions 101b_1 are partly protruded from the flange 101b_11 and the engagement portion 102a_1 is caused to engage on the mounting portions 101b_1. This reduces the contact area between the reflector component 101_1 and the reflector component 102_1. On the other hand, to stably support the reflector component 102_1, it is preferable that the mounting portions 101b_1 are arranged substantially uniformly on the inner circumference of the reflector component 101_1 and are connected to the reflector component 101_1 with a sufficient strength.

The reflector component 101_1 includes the engagement portion 101a_1 protruded in the radial direction (D2) on the outer side of an end portion opposite to the mounting portions 101b_1 as illustrated in FIGS. 4B and 4C. That is, the engagement portion 101a_1 is also provided as a flange of the reflector component 101_1. The engagement portion 101a_1 can be provided on the entire outer circumference of the reflector component 101_1. In this case, it suffices that the engagement portions 103a of the cover 103 in FIG. 3 are partly and substantially uniformly arranged similarly to the mounting portions 101b_1. Accordingly, the engagement portion 101a_1 has a small contact area with the engagement portions 103a even when the engagement portion 101a_1 is provided on the entire outer circumference of the reflector component 101_1.

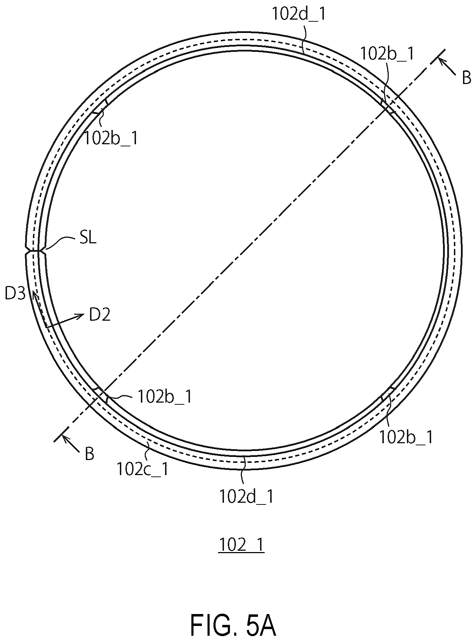

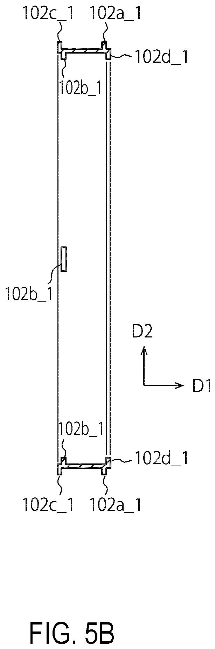

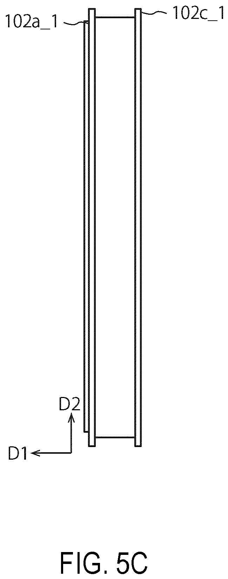

FIG. 5A is a plan view illustrating a configuration example of another reflector component 102_1. FIG. 5B is a cross-sectional view along a line B-B in FIG. 5A. FIG. 5C is a side view illustrating the configuration example of the reflector component 102_1. The configuration of the reflector component 102_1 is explained with reference to FIGS. 5A to 5C. Since the configuration of the reflector component 102_2 is basically the same as that of the reflector component 102_1 while the diameter is different, explanations thereof are omitted. The reflector component 102_1 is made of, for example, a material obtained by depositing a SiC film or a TaC film on a carbon material.

As illustrated in FIG. 5A, the reflector component 102_1 includes the mounting portions 102b_1 protruded in the radial direction (D2) on the inner side. The mounting portions 102b_1 are not provided on the entire inner circumference of the reflector component 102_1 but are arranged partly and substantially uniformly, for example, at four positions on the inner circumference as illustrated in FIG. 5A. It suffices that the mounting portions 102b_1 can stably support the reflector component 101_2 and are substantially uniformly arranged at least at three positions.

If the mounting portions 102b_1 are provided on the entire inner circumference of the reflector component 102_1, there is a possibility that the contact area with the engagement portion 101a_2 of the reflector component 101_2 increases. In this case, the thermal conductivity between the reflector component 101_2 and the reflector component 102_1 becomes relatively high. Therefore, the heat insulation effect of the first reflector unit 100a is reduced.

Therefore, it is preferable that the mounting portions 102b_1 are provided partly and in a small area to reduce the contact area with the engagement portion 101a_2. On the other hand, to stably support the reflector component 101_2, it is preferable that the mounting portions 102b_1 are arranged substantially uniformly on the inner circumference of the reflector component 102_1 and are connected to the reflector component 102_1 with a sufficient strength.

Meanwhile, the reflector component 102_1 includes the protruded portion 102d_1 protruded in the radial direction (D2) on the inner side of an end portion opposite to the mounting portions 102b_1 as illustrated in FIG. 5B. It is preferable that the protruded portion 102d_1 is provided on the entire inner circumference of the reflector component 102_1 as illustrated in FIG. 5A. The protruded portion 102d_1 is provided to suppress heat radiation from entering between the reflector component 102_1 and the reflector component 101_2 while not in contact with other reflector components. Therefore, entry of the heat radiation can be effectively suppressed by provision of the protruded portion 102d_1 on the entire inner circumference of the reflector component 102_1. As a result, the heat insulation effect of the first reflector unit 100a is improved.

As illustrated in FIGS. 5B and 5C, the reflector component 102_1 includes the engagement portion 102a_1 protruded in the radial direction (D2) on the outer side. The engagement portion 102a_1 can be provided on the entire outer circumference of the reflector component 102_1. In this case, it suffices that the mounting portions 101b_1 of the reflector component 101_1 in FIG. 3 are partly and substantially uniformly arranged similarly to the mounting portions 102b_1. This enables the engagement portion 102a_1 to have a small contact area with the mounting portions 101b_1 even when the engagement portion 102a_1 is provided on the entire outer circumference of the reflector component 102_1.

As illustrated in FIGS. 5B and 5C, the reflector component 102_1 includes the protruded portion 102c_1 protruded in the radial direction (D2) on the outer side of an end portion opposite to the engagement portion 102a_1. It is preferable that the protruded portion 102c_1 is provided on the entire outer circumference of the reflector component 102_1 as illustrated in FIG. 5A. The protruded portion 102c_1 is provided to suppress heat radiation from entering between the reflector component 102_1 and the reflector component 101_1 while not in contact with other reflector components. Therefore, with provision of the protruded portion 102c_1 on the entire outer circumference of the reflector component 102_1, entry of the heat radiation can be effectively suppressed. As a result, the heat insulation effect of the first reflector unit 100a is improved.

In the present embodiment, the reflector components 101_1, 102_1, 101_2, 102_2, and 104 may be continuous cylinders. However, each of the reflector components may have a slit (a notch) SL at a part as illustrated in FIGS. 4A and 5A. The slit SL can absorb expansion or contraction of the reflector component due to heat and suppress a thermal stress applied on the reflector component itself.

In the embodiment described above, the mounting portions 101b_1 of the reflector component 101_1 are arranged partly in the circumferential direction and the engagement portion 102a_1 of the reflector component 102_1 that is in contact with the mounting portions 101b_1 is provided on the entire circumference. However, it is possible that the mounting portion 101b_1 is conversely provided on the entire circumference and the engagement portions 102a_1 are provided partly in the circumferential direction.

Further, both of the mounting portions 101b_1 and the engagement portions 102a_1 may be provided partly in the circumferential direction. In this case, the mounting portions 101b_1 and the engagement portions 102a_1 need to be arranged to be in contact with each other substantially uniformly in the circumferential direction.

That is, it suffices that the engagement portions 101a_1 and 101a_2 or the mounting portions 101b_1 and 101b_2 are arranged partly and substantially uniformly at least at three positions in the circumferential direction of the reflector components 101_1 and 101_2. It suffices that the engagement portions 102a_1 and 102a_2 or the mounting portions 102b_1 and 102b_2 are arranged partly and substantially uniformly at least at three positions in the circumferential direction of the reflector components 102_1 and 102_2. This can suppress the contact area between adjacent reflector components and can reduce the contact area with the mounting portions 101b_1.

Each of the engagement portions 103a and 104a of the cover 103 and the reflector component 104 also may be arranged partly and substantially uniformly at least at three positions in the circumferential direction. Accordingly, the contact area between the cover 103 and the top plate 110, and the contact area between the reflector component 104 and the reflector component 102_2 can be reduced. This enables a further improvement of the heat insulation effect of the first reflector unit 100a. With the substantially uniform arrangement of the engagement portions 103a, the cover 103 can stably support other reflector components 101_1, 102_1, 101_2, 102_2, and 104. In this case, the phases of the engagement portions 101a_1, 101a_2, 103a, and 104a, and the mounting portions 101b_1 and 101b_2 can be different from each other as long as they can support reflector components on their inner circumference sides. With this configuration, a heat conducting path to the top plate 110 can be elongated and the top plate 110 can be protected from heat.

As illustrated in FIG. 3, the first reflector unit 100a may further include heat insulators 101e_1, 102e_1, 101e_2, and 102e_2 that are provided at contact parts between adjacent reflector components. For example, the heat insulator 101e_1 is provided between the mounting portions 101b_1 and the engagement portion 102a_1. The heat insulator 102e_1 is provided between the mounting portions 102b_1 and the engagement portion 101a_2. The heat insulator 101e_2 is provided between the mounting portions 101b_2 and the engagement portion 102a_2. The heat insulator 102e_2 is provided between the mounting portions 102b_2 and the engagement portion 104a.

In this way, the heat insulators 101e_1, 102e_1, 101e_2, and 102e_2 can further suppress heat conduction at the contact parts between adjacent reflector components. This can further improve the heat insulation effect of the first reflector unit 100a.

### (Second embodiment)

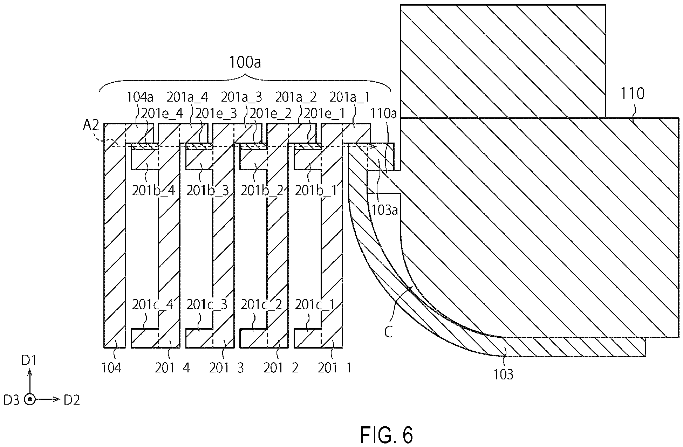

FIG. 6 is a cross-sectional view illustrating a configuration example of the first reflector unit 100a according to a second embodiment. In the second embodiment, reflector components 201_1 to 201_4 have substantially the same sectional shapes. Engagement portions 201a_1 to 201a_4 of the reflector components 201_1 to 201_4 and the engagement portion 104a of the reflector component 104 are at substantially the same heights and mounting portions 201b_1 to 201b_4 are also at substantially the same heights. The rest of the configuration in the second embodiment may be identical to the corresponding one in the first embodiment.

The first reflector unit 100a includes the reflector components 201_1 to 201_4 and 104, and the cover 103.

Each of the reflector components 201_1 to 201_4 has a configuration in which the engagement portion 102a_1 is omitted from the reflector component 102_1 in the first embodiment. For example, the reflector components 201_1 to 201_4 have mounting portions 201b_1 to 201b_4 extending inward in the radial direction (D2) and have the engagement portions 201a_1 to 201a_4 extending outward in the radial direction (D2) at upper ends, respectively, in a cross section in the radial direction (D2). The engagement portions 201a_1 to 201a_4 engage with the cover 103 and the mounting portions 201b_1 to 201b_3, respectively. The mounting portions 201b_1 to 201b_4 extend inward in the radial direction (D2) and mount the engagement portions 201a_2 to 201a_4 and 104a and support the reflector components 201_2 to 201_3 and 104, respectively. The engagement portions 201a_1 to 201a_4 and 104 and the mounting portions 201b_1 to 201b_4 also have functions and effects identical to those of the engagement portion 101a_2 and the mounting portion 102b_1.

The reflector components 201_1 to 201_4 have protruded portions 201c_1 to 201c_4 extending inward in the radial direction (D2) at lower ends, respectively. The protruded portions 201c_1 to 201c_4 suppress heat radiation from below from entering between the reflector components 201_1 to 201_4 and 104, and suppress the reflector components 201_1 to 201_4 and 104 from being directly heated by the heat radiation. The protruded portions 201c_1 to 201c_4 suppress the process gas from below from entering between the reflector components 201_1 to 201_4 and 104 and suppress deposits from adhering to the reflector components 201_1 to 201_4 and 104.

The reflector components 201_1 to 201_4 have substantially the same shapes in the cross section illustrated in FIG. 6 while the diameter sizes are different. Therefore, in the first reflector unit 100a of the second embodiment, the reflector components 201_1 to 201_4 are arrayed in a layered manner in the radial direction. The number of the reflector components 201_1 to 201_4 arrayed between the cover 103 and the reflector component 104 is not particularly limited to the illustrated example and can be less than four, or more than four.

In the present embodiment, the engagement portion 201a_1 of the reflector component 201_1 is in contact with the cover 103, the engagement portion 201a_2 of the reflector component 201_2 is in contact with the mounting portion 201b_1 of the reflector component 201_1, the mounting portion 201b_2 of the reflector component 201_2 is in contact with the engagement portion 201a_3 of the reflector component 201_3, the mounting portion 201b_3 of the reflector component 201_3 is in contact with the engagement portion 201a_4 of the reflector component 201_4, and the mounting portion 201b_4 of the reflector component 201_4 is in contact with the engagement portion 104a of the reflector component 104. Contact positions between the engagement portions 201a_1 to 201a_4 and 104a and the mounting portions 201b_1 to 201b_4 are at substantially the same heights. However, in other parts, the cover 103 and the reflector components 201_1 to 201_4 and 104 are not in contact with each other. Therefore, while the contact surfaces of the adjacent reflector components are not as distant as those in the first embodiment are, the areas of the contact surfaces are limited. The heat conducting path of the first reflector unit 100a is relatively short as indicated by a dashed arrow A2 in FIG. 6. However, since the contact areas between adjacent reflector components are small, heat of the reflector component 104 is less likely to be conducted to the top plate 110. As a result, the first reflector unit 100a can effectively block heat radiation from the substantially horizontal direction and can protect the top plate 110 from heat.

The configuration of each of the reflector components 201_1 to 201_4 is obtained by omitting the engagement portion 102a_1 from the reflector component 102_1 illustrated in FIGS. 5A to 5C. Therefore, the configurations of the reflector components 201_1 to 201_4 can be easily understood by referring to FIGS. 5A to 5C, and illustrations thereof are omitted.

As illustrated in FIG. 6, the first reflector unit 100a may further include heat insulators 201e_1 to 201e_4 that are provided at contact parts between adjacent reflector components. For example, the heat insulators 201e_1 to 201e_4 are provided between the mounting portions 201b_1 to 201b_4 and the engagement portions 201a_2 to 201a_4 and 104a, respectively. Accordingly, the heat insulators 201e_1 to 201e_4 can further suppress heat conduction at the contact parts between adjacent reflector components. This further improves the heat insulation effect of the first reflector unit 100a.

### (Modification)

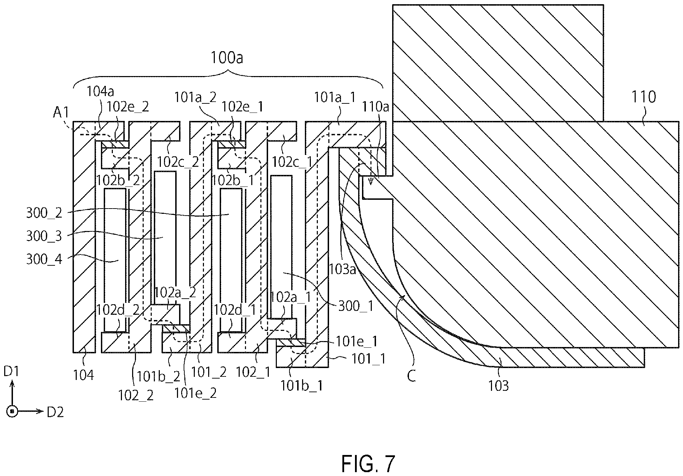

FIG. 7 is a cross-sectional view illustrating a configuration example of the first reflector unit 100a according to a modification of the first embodiment. The modification further incudes heat insulators 300_1 to 300_4 arranged in spaces between adjacent reflector components. Each of the heat insulators 300_1 to 300_4 has a substantially cylindrical shape. Each of the heat insulators 300_1 to 300_4 may have a slit or may be divided into a plurality of pieces.

For example, the heat insulator 300_1 is arranged in the space between the reflector component 101_1 and the reflector component 102_1. The heat insulator 300_2 is arranged in the space between the reflector component 102_1 and the reflector component 101_2. The heat insulator 300_3 is arranged in the space between the reflector component 101_2 and the reflector component 102_2. The heat insulator 300_4 is arranged in the space between the reflector component 102_2 and the reflector component 104.

For example, a material being low in the thermal conductivity, such as a molded heat insulator of carbon fiber coated with graphite is used as the heat insulators 300_1 to 300_4. This enables the first reflector unit 100a to effectively block heat radiation from the horizontal direction and to more effectively protect the top plate 110 from heat.

The rest of the configuration in the present modification may be identical to the corresponding one in the first embodiment. Accordingly, the present modification can further provide effects identical to those of the first embodiment.

The heat insulators 300_1 to 300_4 of the present modification are also similarly applicable to the second embodiment.

### (Third embodiment)

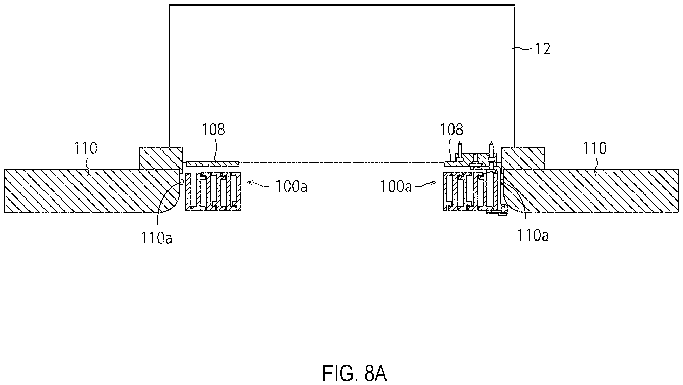

FIG. 8A is a cross-sectional view illustrating a configuration example of the first reflector unit 100a according to a third embodiment. In the third embodiment, the support method for the first reflector unit 100a is different from those in the above embodiments. The first reflector unit 100a is supported by first and second support members 400 and 410 fixed by coupling members 510 via an attachment portion 108 attached to the gas supplier 12. The attachment portion 108 is a member having a substantially annular shape along the inner edge of the top plate 110. For example, it is preferable that the attachment portion 108 is made of a material having a resistance to heat equal to or higher than 700°C, such as carbon, Hastelloy (registered trademark), quartz, SiC, TaC, W, Mo, or a material obtained by depositing a SiC film or a TaC film on carbon.

The first reflector unit 100a is provided below the attachment portion 108. Accordingly, the attachment portion 108 protects the gas supplier 12 from heat radiated from the first reflector unit 100a. Furthermore, deposits can be prevented from adhering to the inner wall of the chamber 13 and the reflectance of the inner wall can be maintained. It is also possible that the attachment portion 108 is omitted to directly fix the support members 400 and 410 to the gas supplier 12.

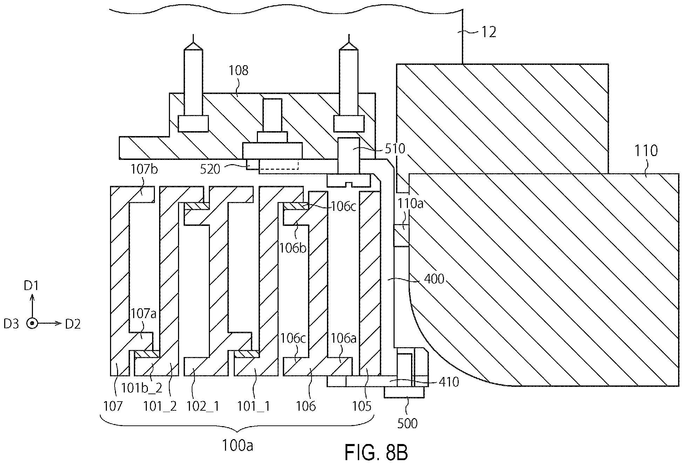

FIG. 8B is a cross-sectional view illustrating a more detailed configuration example of the first reflector unit 100a. The first reflector unit 100a includes reflector components 101_1 to 107, the first support members 400, and the second support members 410.

The first and second support members 400 and 410 are coupled to each other by coupling members 500. The first support members 400 are coupled to an upper part of the gas supplier 12 by the coupling members 510 and coupling members 520 via the attachment portion 108. The coupling members 500, 510, and 520 are, for example, fasteners such as bolts.

The first support members 400 are fixed to an upper part of the chamber 13. Each of the second support members 410 is fixed to the associated first support member 400 and is supported by the first support member 400. The second support members 410 mount a cover 105 and the reflector component 106 on the upper surfaces and support the cover 105 and the reflector component 106. The cover 105 and the reflector component 106 support other reflector components 101_1, 102_1, 101_2, and 107. Accordingly, the first and second support members 400 and 410 can support the entire first reflector unit 100a to be placed on the chamber 13 and the top plate 110. Since no reflector unit is placed on the protruded portions 110a in the third embodiment, the protruded portions 110a may be omitted.

It is preferable that the first reflector unit 100a, the first and second support members 400 and 410, and the coupling members 510 and 520 are made of, for example, a material having a resistance to heat equal to or higher than 700°C, such as carbon, Hastelloy (registered trademark), quartz, SiC, TaC, W, Mo, or a material obtained by depositing a SiC film or a TaC film on carbon.

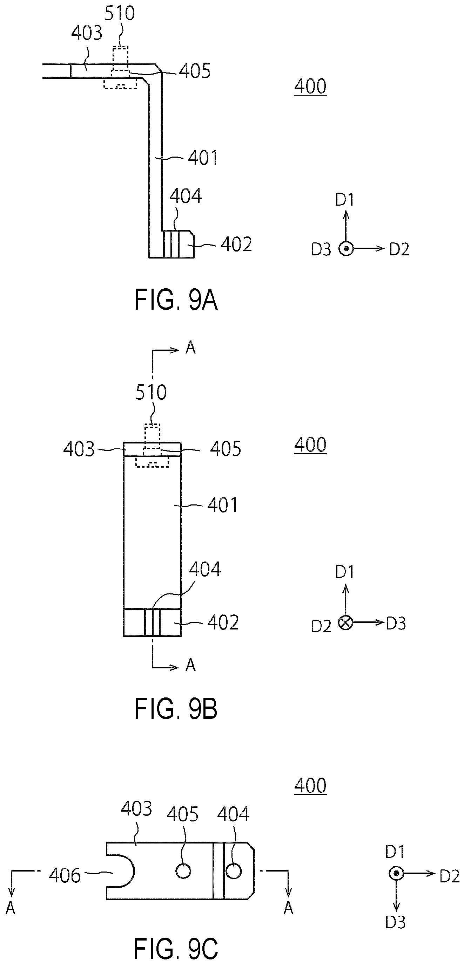

FIGS. 9A to 9C are diagrams illustrating a configuration example of the first support member 400. FIG. 9A illustrates a cross-sectional view of the first support member 400 seen from a side surface thereof. FIG. 9B illustrates a cross-sectional view of the first support member 400 seen from the front. FIG. 9C illustrates a plan view of the first support member 400. FIG. 9A illustrates a cross section along a line A-A in FIGS. 9B and 9C.

The first support member 400 includes a body 401, and protruded portions 402 and 403. The body 401 is a plate-like member extending in the D1 direction. The protruded portion 402 is provided at one end of the body (the plate-like member) 401 to be protruded in a substantially orthogonal direction (a +D2 direction). The protruded portion 403 is provided at the other end of the body (the plate-like member) 401 to be protruded in a substantially orthogonal direction (a -D2 direction) opposite to the protruded portion 402. It is preferable that the body 401 and the protruded portions 402 and 403 are integrally formed.

The protruded portion 402 includes an opening 404 that allows the coupling member 500 to pass through. The protruded portion 403 includes an opening 405 that allows the coupling member 510 to pass through. The openings 404 and 405 correspond, for example, to bolts of the coupling members 500 and 510 and can be nuts that are screwed on the bolts. The protruded portion 403 further includes a cutout 406. By fitting a part of the coupling member 520 in the cutout 406, the coupling members 510 and 520 fix the orientation of the first support member 400 with respect to the top plate 110.

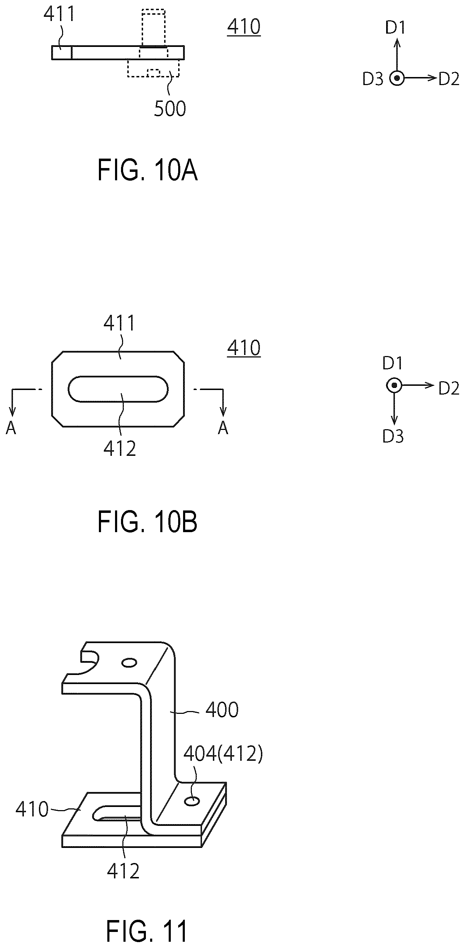

FIGS. 10A and 10B are diagrams illustrating a configuration example of the second support member 410. FIG. 10A illustrates a cross-sectional view of the second support member 410 seen from a side surface thereof. FIG. 10B illustrates a plan view of the second support member 410. FIG. 10A illustrates a cross section along a line A-A in FIG. 10B.

The second support member 410 is a substantially rectangular plate-like member. The second support member 410 includes an opening 412 that allows the coupling member 500 to pass through. The opening 412 has, for example, an elongated circular shape or a substantially elliptic shape and the minor axis is formed slightly larger than a threaded portion of the coupling member 500 to enable the threaded portion to pass through.

FIG. 11 is a perspective view illustrating a configuration example of the coupled first and second support members 400 and 410. The opening 412 of the second support member 410 is communicated with the opening 404 of the first support member 400 and the coupling member 500 passes therethrough. By screwing the coupling member 500 into the opening 404 of the first support member 400, the second support member 410 is secured between the coupling member 500 and the first support member 400 and is fixed. With the elongated circular shape or the substantially elliptical shape of the opening 412 of the second support member 410, the relative position of the second support member 410 with respect to the first support member 400 can be changed to the D2 direction.

The first and second support members 400 and 410 having the configuration descried above are attached to the upper surface of the inner wall of the chamber 13 as illustrated in FIGS. 8. It is preferable that the number of the attached first and second support members 400 and 410 is larger to sufficiently support the first reflector unit 100a. On the other hand, it is preferable that the number thereof is smaller to suppress heat transfer from the first reflector unit 100a to the top plate 110. Therefore, the number of the attached first and second support members 400 and 410 is set to a value that enables the first reflector unit 100a to be sufficiently supported and enables heat transfer from the first reflector unit 100a to the top plate 110 to be suppressed as much as possible. For example, the number of the attached first and second support members 400 and 410 is at least three. Of course, the number of the attached first and second support members 400 and 410 can be four or more.

It is preferable that the attachment positions of the first and second support members 400 and 410 are substantially uniformly arranged on the inner circumference of the top plate 110 to substantially uniformly support the first reflector unit 100a and substantially uniformly disperse heat transfer from the first reflector unit 100a to the top plate 110.

In the third embodiment, with the provision of the cover 105, the cover 103 of the top plate 110 can be omitted. The first support members 400 are not in contact with the protruded portions 110a and the top plate 110. Therefore, the first support members 400 can further suppress heat transfer from the first reflector unit 100a to the top plate 110.

The configuration of the first reflector unit 100a is explained in more detail with referring again to FIGS. 8. The first reflector unit 100a includes the reflector components 101_1 to 107. The configurations of the reflector components 101_1, 102_1, and 101_2 may be identical to those of the first embodiment. Accordingly, explanations of the reflector components 101_1, 102_1, and 101_2 are omitted.

The cover 105 has a substantially cylindrical shape to cover the inner circumferential portion C of the top plate 110. That is, the cover 105 is arranged in such a manner that the side wall covers the inner circumferential portion C of the top plate 110 in the vertical direction (D1) and the circumferential direction (D3).

The cover 105 extends in a substantially straight line in the D1 direction in a cross section in the radial direction (D2) and is supported from the bottom surface by the second support member 410. When the first and second support members 400 and 410 are attached at three positions on the inner circumference of the top plate 110, the cover 105 is supported at the three positions by three sets of the first and second support members 400 and 410.

The cover 105 can suppress the support members 400 and 410 and the top plate 110 from being directly heated by heat radiation from the reflector components 106, 101_1, 102_1, 101_2, and 107. Furthermore, the cover 105 can suppress the process gas from being brought into contact with the support members 400 and 410 and the top plate 110 to cause adhesion of deposits.

The reflector component 106 has a substantially cylindrical shape to cover the inner circumferential portion C of the top plate 110. The reflector component 106 is arranged in such a manner that the side wall covers the inner surface of the cover 105 in the vertical direction (D1) and the circumferential direction (D3).

The reflector component 106 has a mounting portion 106b protruded inward at an upper part and an engagement portion 106a protruded outward at a lower end in a cross section in the radial direction (D2). The engagement portion 106a engages with the second support member 410 and is supported by the second support member 410. The mounting portion 106b is protruded inward to mount the reflector component 101_1. As described above, the reflector component 106 has the mounting portion 106b at the upper part and the engagement portion 106a at the lower end. Therefore, the reflector component 106 can engage with the second support member 410 by its own weight to be supported thereby, and can mount and support the reflector component 101_1.

A part of the reflector component 106 extending in the vertical direction (D1) has an outside diameter slightly smaller than the inside diameter of the cover 105 to enable the part to be placed on the inner side of the cover 105. Meanwhile, a circumscribed circle of the engagement portion 106a is formed to be positioned on an outer side than the inner end of the second support member 410 to enable the engagement portion 106a to be hung on the second support member 410. With this configuration, the reflector component 106 is placed in a state of covering the inner circumferential surface of the cover 105.

The reflector component 106 further has a protruded portion 106c protruded inward in the radial direction (D2) at the lower end. The protruded portion 106c suppresses heat radiation from below from entering between the reflector component 106 and the reflector component 101_1 and suppresses the reflector components 106 and 101_1 from being directly heated by the heat radiation. Furthermore, the protruded portion 106c suppresses the process gas from below from entering between the reflector component 106 and the reflector component 101_1 and suppresses deposits from adhering to the reflector components 106 and 101_1. Accordingly, the reflectances of heat radiation of the reflector components 106 and 101_1 can be maintained.

The engagement portion 106a and the mounting portion 106b also have functions identical to those of the protruded portion 106c. That is, the engagement portion 106a suppresses heat radiation from below from entering between the cover 105 and the reflector component 106. The mounting portion 106b suppresses heat radiation from above from entering between the reflector component 106 and the reflector component 101_1. Furthermore, the engagement portion 106a suppresses the process gas from below from entering between the cover 105 and the reflector component 106. The mounting portion 106b suppresses the process gas from above from entering between the reflector component 106 and the reflector component 101_1. The configurations and functions of the reflector components 101_1, 102_1, and 101_2 are identical to those of the first embodiment and therefore explanations thereof are omitted here.

The reflector component 107 has a substantially cylindrical shape to cover the inner wall of the reflector component 101_2 at the inner circumferential portion C of the top plate 110. The reflector component 107 can be, for example, a material obtained by depositing a SiC film or a TaC film on a carbon material. However, since the reflector component 107 is the innermost reflector component of the first reflector unit 100a, it is preferable that the reflector component 107 is made of a material obtained by coating a carbon material with a SiC film.

The reflector component 107 has an engagement portion 107a protruded outward in the radial direction (D2) at a lower part. The engagement portion 107a of the reflector component 107 engages with the mounting portion 101b_2 of the reflector component 101_2 adjacent on the outer side and is supported by the mounting portion 101b_2. As described above, the reflector component 107 has the engagement portion 107a at the lower part of the body extending in the vertical direction (D1). Accordingly, the reflector component 107 can be supported by engaging with the mounting portion 101b_2 of the reflector component 101_2 by its own weight.

A part of the reflector component 107 extending in the vertical direction (D1) has an outside diameter slightly smaller than the inside diameter of the reflector component 101_2 to enable the part to be placed on the inner side of the reflector component 101_2. Meanwhile, the diameter of a circumscribed circle of the engagement portion 107a is slightly larger than the diameter of an inscribed circle of the mounting portion 101b_2 of the reflector component 101_2 to cause the engagement portion 107a to be hung on the mounting portion 101b_2 of the reflector component 101_2. With this configuration, the reflector component 107 can be placed in a state of covering the inner circumferential surface of the reflector component 101_2.

The reflector component 107 further has a protruded portion 107b protruded outward in the radial direction (D2) at the upper end. The protruded portion 107b suppresses heat radiation from above from entering between the reflector component 107 and the reflector component 101_2 and suppresses the reflector components 107 and 101_2 from being directly heated by the heat radiation. Furthermore, the protruded portion 107b suppresses the process gas from above from entering between the reflector component 107 and the reflector component 101_2 and suppresses deposits from adhering to the reflector components 107 and 101_2. Accordingly, the reflectances of heat radiation of the reflector components 107 and 101_2 can be maintained.

The engagement portion 107a also has functions identical to those of the protruded portion 107b and suppresses heat radiation from below from entering between the reflector component 101_2 and the reflector component 107. Furthermore, the engagement portion 107a suppresses the process gas from below from entering between the reflector component 101_2 and the reflector component 107. Accordingly, the engagement portion 107a can provide effects identical to those of the protruded portion 107b.

The number of sets each including the reflector components 101_1, 102_1, and 101_2 provided between the reflector component 106 and the reflector component 107 is not particularly limited to the illustrated example and can be two or more.

The rest of the configuration in the third embodiment may be identical to the corresponding one in the first embodiment. Accordingly, the third embodiment can further provide effects identical to those of the first embodiment. The support method in the third embodiment is also applicable to conventional stacked reflectors that are stacked in the Z direction.

### (Modification)

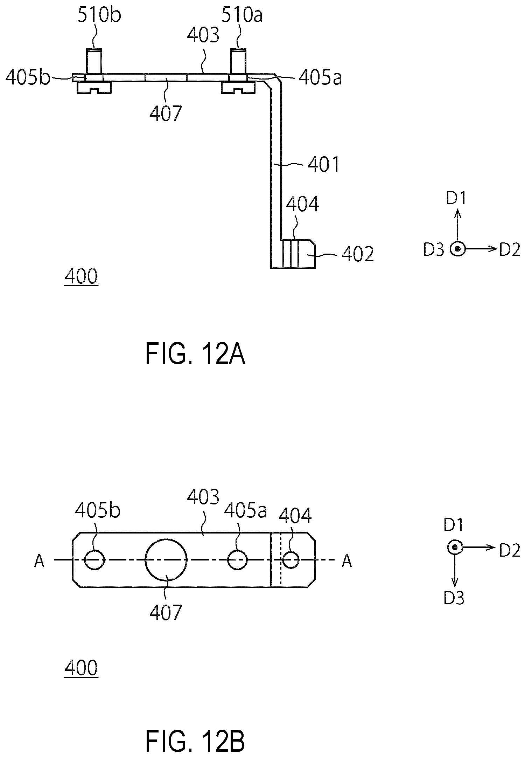

FIG. 12A is a side view illustrating another configuration example of the coupled first support member 400 seen from a side surface. FIG. 12B is a plan view illustrating the configuration example of the coupled first support member 400. The support member 410 may be identical to that illustrated in FIG. 10.

In the present modification, a plurality of openings 405a, 405b, and 407 are formed on the protruded portion 403. The openings 405a and 405b correspond, for example, to bolts of coupling members 510a and 510b and can be nuts that are screwed on the bolts. The support members 400 and 410 are attached to the upper surface of the inner wall of the chamber 13 by the coupling members 510a and 510b through the openings 405a and 405b. This enables the support members 400 and 410 to be more firmly fixed to the chamber 13.

By fitting the coupling member 520 in the opening 407, the coupling members 510a, 510b, and 520 fix the orientation of the support member 400 with respect to the top plate 110.

The rest of the configuration of the first support member 400 according to the present modification may be identical to the corresponding one of the first support member 400 according to the third embodiment. Accordingly, the present modification can provide effects identical to those of the third embodiment.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. A reflector unit comprising:
a cylindrical first reflector component having a first engagement portion on an outer circumference side to be supported by a film formation chamber, and a first mounting portion on an inner circumference side; and
a cylindrical second reflector component arranged on an inner side of the first reflector component and having a second engagement portion on an outer circumference side to engage with the first reflector component on the first mounting portion to be supported by the first reflector component.

2. The reflector unit of Claim 1, wherein the first engagement portion is different from the second engagement portion in at least either a position in a vertical direction or a phase in a horizontal direction.

3. The reflector unit of Claim 1, wherein at least one of the first engagement portion, the first mounting portion, and the second engagement portion is arranged partly and substantially uniformly at least at three positions in a circumferential direction.

4. The reflector unit of Claim 1, wherein
the second reflector component further has a second mounting portion on an inner circumference side, and
the unit comprises a cylindrical third reflector component arranged on an inner side of the second reflector component and having a third engagement portion on an outer circumference side to engage with the second reflector component on the second mounting portion to be supported by the second reflector component.

5. The reflector unit of Claim 1, further comprising a first heat insulator between the first mounting portion and the second engagement portion.

6. The reflector unit of Claim 1, wherein a member obtained by depositing a SiC (silicon carbide) film or a TaC (tantalum carbide) film on carbon is used as the first and second reflector components.

7. The reflector unit of Claim 1, further comprising a second heat insulator arranged in a space between the first reflector component and the second reflector component and having a substantially cylindrical shape.

8. A film forming apparatus comprising:
a chamber including a top plate having an opening on an upper part, and configured to accommodate a substrate to perform film formation processing;
a gas supplier located above the chamber and configured to supply a source gas onto the substrate through the opening of the top plate;
a heater configured to heat the substrate; and
the reflector unit of Claim 1 installed in the opening of the top plate.

9. The film forming apparatus of Claim 8, wherein the reflector unit is fixed by engaging with the top plate.

10. The film forming apparatus of Claim 8, wherein the reflector unit is fixed to an attachment portion attached to the gas supplier.
